# EUROPEAN PATENT APPLICATION

(11) **EP 4 462 205 A1**
(43) Date of publication of application: **13.11.2024**
(21) Application number: 24163846.9
(22) Date of filing: 15.03.2024
(51) Int. Cl.: G05B 19/4093, G05B 19/409

(54) **METHOD AND SYSTEM FOR CONFIGURING A CNC MACHINE**

(30) Priority: 08.05.2023 FI 20235506
(71) Applicant: LCSA System Oy, 32700 Huittinen (FI)
(72) Inventor: Gunerka, Adrian, 21870 Riihikoski (FI)
(74) Representative: Moosedog Oy

(57) **Abstract**

Disclosed is a method (300) and a system (100) for configuring a CNC machine (106) to machine a blank (116) to a machined part involving creating a 3D model of the machined part (114) and providing the blank to the CNC machine. An AR/MR device (104) is used for rendering the 3D model as an overlay to the blank, positioning and aligning the overlay with respect to the CNC machine, and providing indication therefor. The method sets an origin point by selecting a point on the overlay, indicating where CNC machining dimensions begin. A machining program (118) is created by using the AR/MR device to select a machining tool or cutting insert, tip a surface of the blank, present a machining cycle to be approved or disapproved. The process is repeated until the machining program is ready for simulation. Finally, the CNC machine is configured with the created machining program.

## Description

### TECHNICAL FIELD

The present disclosure relates to a method for configuring a CNC machine to machine a blank to a machined part. Moreover, the present disclosure relates to a system for configuring a CNC machine to machine a blank to a machined part. Furthermore, the present disclosure relates to a machining program to be installed on a CNC machine.

### BACKGROUND

In recent years, Computer Numerical Control (CNC) machines have revolutionized the manufacturing industry by automating complex machining processes, ensuring high precision and efficiency in the production of machined parts. These machines are controlled by a set of coded instructions called a CNC program or a machining program, which is generated based on the desired end product. The machining program controls the movement of cutting tools, enabling the creation of intricate shapes and designs with minimal human intervention. The machining program is a critical aspect of the manufacturing process, as it determines the accuracy, efficiency, and quality of the final product. With the growing complexity of CNC machines and the increasing demand for precision in manufacturing, there is a continuous need for advancements in techniques employed for generating such machining programs for the CNC machines.

However, the manual process of creating the machining program, configuring the CNC machine, and verifying the program's correctness can be time-consuming, error-prone, and dependent on the experience and skill of the operator. Additionally, the selection of appropriate machining tools, cutting inserts and machining parameters is required to reduce material waste, but performing it manually may again add to time consumed and increase in errors, resulting in production delays, and higher costs. Furthermore, the visualization of the final machined part and the alignment of the workpiece can be challenging for the user, often requiring trial and error to achieve the desired accuracy and positioning.

Therefore, in light of the foregoing discussion, there exists a need to overcome the aforementioned drawbacks.

### SUMMARY

The aim of the present disclosure is to provide a method and a system to leverage the power of Augmented-Reality (AR)/ Mixed-Reality (MR) technology to create (generate) the machining program for the CNC machine. The aim of the present disclosure is achieved by a method and a system for configuring the CNC machine to machine a blank to a machined part as defined in the appended independent claims to which reference is made to. Advantageous features are set out in the appended dependent claims.

Throughout the description and claims of this specification, the words "*comprise",* "*include",* "*have",* and "*contain"* and variations of these words, for example "*comprising"* and "*comprises",* mean "*including but not limited to*"*,* and do not exclude other components, items, integers or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

### BRIEF DESCRIPTION OF THE DRAWINGS

FIG. 1 is an illustration of schematic block diagram of a system for configuring a CNC machine to machine a blank to a machined part, in accordance with an embodiment of the present disclosure;
FIG. 2 is an illustration of an exemplary depiction of a user interface, in accordance with an embodiment of the present disclosure; and
FIG. 3 is an illustration of a flowchart listing steps involved in a method for configuring a CNC machine to machine a blank to a machined part, in accordance with an embodiment of the present disclosure.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

In a first aspect, the present disclosure provides a method for configuring a Computer Numerical Control (CNC) machine to machine a blank to a machined part, the method comprising:
- creating a 3D model of the machined part;
- providing the blank to the CNC machine;
- using an Augmented-Reality (AR)/ Mixed Reality (MR) device for:
   - rendering the 3D model of the machined part, as an overlay to the blank;
   - positioning and aligning the overlay in respect to the CNC machine;
   - providing indication if the overlay is positioned and aligned based on predetermined tolerances;
   - setting an origin point by selecting a point on the overlay, wherein the origin point indicates where one or more dimensions for CNC machining begin;
- creating a machining program for the CNC machine to machine the blank to the machined part, by repeating steps (i),(ii),(iii),(iv), until the machining program is ready for simulation by using the AR/MR device for:
   (i) selecting a machining tool and/or a cutting insert from a list comprising a set of machining tools and a set of cutting inserts;
   (ii) tipping a surface of the blank with the selected machining tool or cutting insert;
   (iii) presenting a machining cycle for machining the blank to the machined part;
   (iv) approving or disapproving the presented machining cycle and including the approved machine cycle in the machining program;
- simulating the created machining program; and
- configuring the CNC machine with the created machining program, the method further comprising:
- transferring the created machining program to a control system of a physical CNC machine, wherein the control system interprets instructions and commands for the physical CNC machine to perform various operations detailed in the created machining program, so that actual machining process is initiated.

The present method by utilizing AR/MR technology for rendering the 3D model of the machined part and configuring the CNC machine with the created machining program allows users to detect potential issues or errors before actual machining begins, minimizing the risk of material waste and machine damage. The step-by-step approach to creating a machining program, which includes selecting tools and cutting inserts, tipping a surface of the blank, presenting a machining cycle, and approving or disapproving the presented machining cycle, ensures that each aspect of the process is carefully considered and optimized, resulting in a more accurate, efficient, and cost-effective CNC machining process.

In a second aspect, the present disclosure provides a system for configuring a Computer Numerical Control (CNC) machine to machine a blank to a machined part, the system comprising:
- an Augmented-Reality (AR)/ Mixed-Reality (MR) device for:
   - rendering the 3D model of the machined part, as an overlay to the blank;
   - positioning and aligning the overlay in respect to the CNC machine;
   - providing indication if the overlay is positioned and aligned based on predetermined tolerances;
   - setting an origin point by selecting a point on the overlay, wherein the origin point indicates where one or more dimensions for CNC machining begin; and
- a computing unit for creating a machining program, the computing unit configured to use the AR/MR device as user interface for:
   (I) selecting a machining tool and/or a cutting insert from a list comprising a set of machining tools and a set of cutting inserts;
   (II) tipping a surface of the blank with the selected machining tool or the cutting insert;
   (III) presenting a machining cycle for machining the blank to the machined part;
   (IV) approving or disapproving the presented machining cycle and including the approved machine cycle in the machining program, wherein the computing unit is configured to simulate the created machining program and configure the CNC machine with the created machining program,
- wherein the created machining program is transferred to a control system of a physical CNC machine, and wherein the control system interprets instructions and commands for the physical CNC machine to perform various operations detailed in the created machining program, so that actual machining process is initiated.

The present system by utilizing AR/MR technology for rendering the 3D model of the machined part and configuring the CNC machine with the created machining program allows users to detect potential issues or errors before actual machining begins, minimizing the risk of material waste and machine damage. The AR/MR device provides an indication of whether the overlay is positioned and aligned based on predetermined tolerances, and allows users to visualize the final machined part, thereby enhancing the accuracy and efficiency of the machining process. The computing unit uses the AR/MR device as a user interface for selecting machining tools and cutting inserts, tipping the surface of the blank, presenting a machining cycle, and approving or disapproving the presented machining cycle. This interactive process ensures that each aspect of the process is carefully considered and optimized, resulting in a more efficient and accurate CNC machining process.

In a second aspect, the present disclosure provides a machining program, according to the aforementioned method, wherein the created machining program is installed on the CNC machine.

The installation of the created machining program on the CNC machine improves the efficiency, accuracy, and overall quality of the machining process. By having the machining program installed, the CNC machine is provided with detailed instructions that outline the necessary steps to machine the blank into the desired machined part. This eliminates the need for manual intervention and reduces the potential for human error, ensuring that the CNC machine operates consistently and precisely according to the established parameters.

As used herein, the "CNC machine" is a computer-controlled machine tool designed to manufacture parts with high precision and accuracy by interpreting coded instructions called a CNC program. These machines may include various types, such as milling machines, lathes, and routers, depending on the specific manufacturing needs. The present disclosure provides the method for configuring the CNC machine to machine the blank to the machined part. The "blank" is a raw material piece, typically a block, a plate, or other suitable form, which is to be machined into the desired part using the CNC machine. The "machined part" refers to a finished or semi-finished product that has been produced through the process of CNC machining. The machined part typically conforms to the specifications outlined in a 3D model or technical drawing and has specific dimensions, tolerances, and surface finishes to meet functional requirements.

Also, as used herein, the "machining program" refers to a set of instructions that control the operation of the CNC machine to produce the machined part from the blank. The machining program contains information about the sequence of machining operations, tool movements, cutting parameters, and other relevant details required to create the desired part with high precision and accuracy. The machining program is typically represented in G-code, a widely-used programming language for CNC machines. G-code provides a standardized way of communicating toolpath and operational information to the CNC machine.

Further, as used herein, the "AR/MR device" is a device capable of combining digital content, such as 3D models, with the real world, allowing users to interact with and manipulate digital objects in a physical environment. The AR/MR device may be a head-mounted display, a handheld device, or any other suitable device capable of rendering the 3D model and overlaying it on the blank. By utilizing the AR/MR device, the present method provides real-time visualization, validation, and feedback during the CNC programming and machine setup process, improving accuracy, efficiency, and user experience. In one or more examples, the AR/MR device may include, but not limited to, a smartphone or a tablet with AR/MR capabilities such as Apple iPhone^{®}, Apple iPad Pro^{®}, a headset such Microsoft HoloLens^{®}, Google Glass^{®}, and the like.

The method begins by creating the 3D model of the machined part, which serves as a digital representation of the desired final product. This 3D model contains essential information about the part's geometry, dimensions, tolerances, and surface finishes required for the CNC machining process. Next, the blank, which is the initial workpiece to be machined, is provided to the CNC machine. The method then employs the AR/MR device to render the 3D model of the machined part as the overlay to the blank. Herein, the "overlay" refers to the digital representation of the 3D model of the machined part, which is superimposed onto the blank through the AR/MR device. The overlay serves as a visual guide for the user, enabling them to see the desired final shape and position of the machined part in relation to the blank. The overlay is positioned and aligned with respect to the CNC machine, ensuring proper placement of the machined part within the machine's work envelope.

In the present method, the AR/MR device provides the indication if the overlay is positioned and aligned based on predetermined tolerances, ensuring that the machining process will meet the desired accuracy and precision requirements. Herein, the "predetermined tolerances" refer to the allowable deviations from specified dimensions or positions in a part, ensuring that the part meets desired quality and functionality requirements. The origin point is then set by selecting a point on the overlay. Herein, the "origin point" is a reference point on the overlay that indicates where one or more dimensions for CNC machining begin. The origin point indicates where one or more dimensions for CNC machining begin, serving as a reference point for the CNC machine during the machining process.

The method then proceeds with the creation of the machining program for the CNC machine. This is done by using the AR/MR device to execute steps including (i) selecting the machining tool and/or the cutting insert from the list comprising the set of machining tools and the set of cutting inserts; (ii) tipping the surface of the blank with the selected machining tool or cutting insert; (iii) presenting the machining cycle for machining the blank to the machined part; (iv) approving or disapproving the presented machining cycle and including the approved machine cycle in the machining program. As used herein, the "machining tool" is a device or instrument used in CNC machining to remove material from the blank, such as milling cutters, drills, or lathes. Further, the "cutting insert" is a replaceable, typically indexable, cutting element used in conjunction with a machining tool to remove material from the blank during the CNC machining process.

In implementation of the step (i), the AR/MR device may display a list of available machining tools and cutting inserts. The user may interact with the AR/MR device to browse through the list and choose the appropriate tool or insert for a specific operation. The selection of the right machining tool or cutting insert depends on various factors, such as the material of the blank, the desired geometry and surface finish of the machined part, and the specific machining operation to be performed. This interactive selection process ensures that the user may easily choose the most suitable machining tool or cutting insert for each machining operation within the program.

In implementation of the step (ii), the user may use the AR/MR device to virtually tip the surface of the blank where the material removal will occur, once the user has selected the appropriate machining tool or cutting insert. Tipping the surface involves visually indicating the area on the blank where the selected machining tool or cutting insert will engage with the material, providing the user with a clear understanding of how the machining operation will be performed. This step also helps in validating compatibility of the selected machining tool or cutting insert with the intended machining operation, ensuring that the machining program's overall efficiency and effectiveness are maintained.

In implementation of the step (iii), the AR/MR device may present a virtual representation of the machining cycle, which is a sequence of machining operations required to transform the blank into the machined part. As used herein, the "machining cycle" is a series of coordinated machine movements and operations that define a specific machining process, such as drilling, milling, or turning. The user can view the presented machining cycle in real-time, observing the movement of the selected machining tool or cutting insert, and the material removal process. This visualization allows the user to better understand the machining process, making it easier to identify potential issues or inefficiencies in the proposed cycle.

In implementation of the step (iv), the user may review the presented machining cycle, and has the option to approve or disapprove the presented machining cycle using the AR/MR device. If the user approves the cycle, it is included in the machining program, and the user proceeds to the next operation or tool selection. In case the user disapproves of the cycle, the user may modify the selection of the machining tool or cutting insert, adjust the toolpath, or change other relevant parameters to optimize the machining cycle. This iterative process ensures that the final machining program is tailored to produce the desired machined part efficiently and effectively, reducing material waste, and minimizing the risk of errors during the actual machining process.

The method involves repeating the steps (i), (ii), (iii), and (iv) until the machining program is ready for simulation. Herein, the user may be required to repeatedly perform the steps (i), (ii), (iii), and (iv) to create a comprehensive machining program for the CNC machine. Each iteration helps the user refine the machining program by adjusting the selection of machining tool or cutting insert, modifying toolpaths, and altering other relevant parameters as needed. This iterative process is designed to ensure that all necessary machining operations are included in the machining program, and each operation is optimized to produce the desired machined part efficiently and effectively. Once all the required machining operations have been included in the machining program and the user has approved each machining cycle, the machining program is considered ready for simulation.

The method then proceeds to simulating the created machining program. That is, once the machining program is ready, the method proceeds to simulating the created machining program. The simulation is performed using the AR/MR device, which provides a virtual representation of the entire machining process, allowing the user to visualize the CNC machine's operation as it follows the instructions in the machining program. During the simulation, the user can observe the movement of the machining tools or cutting inserts, the material removal process, and the overall transformation of the blank into the machined part. This virtual representation enables the user to identify potential issues, inefficiencies, or collisions that may occur during the actual machining process. Moreover, the simulation allows the user to assess the effectiveness of the selected tools, inserts, and machining cycles in achieving the desired geometry, dimensions, and surface finish of the machined part.

If any issues are identified during the simulation, the user may make the necessary adjustments to the machining program, such as modifying toolpaths, changing the selection of machining tool or cutting insert, or altering cutting parameters. Once the adjustments have been made, the user may run the simulation again to verify that the issues have been resolved and that the machining program will result in the desired machined part.

Finally, the method involves configuring the CNC machine with the created machining program. That is, after the machining program has been successfully simulated, the method proceeds to configure the CNC machine with the created machining program. This step involves transferring the machining program to the CNC machine's control system, which then interprets the instructions and commands the CNC machine to perform the various operations detailed in the machining program, so that the actual machining process may be initiated.

By configuring the CNC machine with the created machining program, the present method enables a seamless transition from the machining program creation and simulation stages to the actual machining process. This streamlined approach minimizes the risk of errors, reduces setup time, and ensures a high level of accuracy and efficiency in producing the desired machined part. Thus, the method allows users to optimize the CNC machining process, resulting in reduced material waste, lower production costs, and higher overall productivity.

In an embodiment, the provided blank is a virtual model blank. Such virtual model blank is a digital representation of the workpiece to be machined. This feature allows users to visualize and plan the machining process in a digital environment without requiring a physical blank. By using the virtual model blank, the user may experiment with various machining strategies, test different tooling options, and optimize the machining program before committing to a physical blank. This approach reduces material waste and saves time, ultimately improving the overall efficiency, accuracy, and cost-effectiveness of the CNC machining process.

In an embodiment, the CNC machine is a virtual CNC machine. Such virtual CNC machine allows users to practice, test, and optimize the machining process in a digital environment before using a physical CNC machine. This feature enables users to fine-tune the machining program and the AR/MR device's overlay settings without the risk of damaging physical equipment or wasting material. By providing the option to use the virtual CNC machine, the present disclosure helps users gain experience, identify potential issues, and refine their machining process before transitioning to a physical CNC machine, ultimately resulting in a more accurate and efficient machining process.

In an embodiment, laser scanning (LIDAR) or a camera or video or a combination of the aforementioned is used for scanning an object for creating the 3D model of the machined part. Laser scanning, or Light Detection and Ranging (LIDAR), is a remote sensing technology that uses laser light to measure distances and create detailed 3D models of objects or environments. Any of the laser scanning and other scanning methods such as cameras or video, may be used independently or in combination for scanning an object to create the 3D model for purposes of the present method. This flexibility allows users to choose the most suitable scanning technology for creating the 3D model based on their specific requirements, equipment availability, and desired level of accuracy. By using accurate scanning technologies, the present disclosure ensures that the 3D model and the subsequent overlay generated in the AR/MR device are precise, leading to a more accurate and efficient CNC machining process.

In an embodiment, machine vision is used for scanning the object. Machine vision refers to the use of cameras, sensors, and computer algorithms to extract, analyse, and interpret visual information from a scene or object, typically for automation or control purposes. Machine vision may be used in conjunction with laser scanning (LIDAR) or other scanning technologies involving a camera or video for creating a 3D model for purposes of the present method. By integrating the machine vision, the present disclosure may further improve the accuracy of the 3D model and the subsequent overlay generated in the AR/MR device, leading to a more precise CNC machining process.

In an embodiment, the origin point is selected automatically using parameters related to model of the CNC machine. This feature eliminates the need for manual input by the user, reducing the potential for errors and inconsistencies in setting the origin point. By automating the origin point selection process, the present disclosure improves the overall accuracy and efficiency of the CNC machining process, ensuring that the CNC machine follows the correct machining program based on the selected origin point.

In an embodiment, the overlay is a holographic model. Such overlay in the form of the holographic model is a three-dimensional visual representation of an object created using light interference patterns. The holographic model may be displayed and manipulated in real-time through the AR/MR device overlapping on the blank. Using the holographic model for the overlay provides a more immersive and realistic visualization of the machined part, allowing the user to better understand the machining process and make more accurate decisions regarding the positioning, alignment, and origin point. This ultimately contributes to improved accuracy, efficiency, and user experience in the CNC machining process.

In an embodiment, the provided indication if the overlay is positioned and aligned based on predetermined tolerances is performed by changing colour of the overlay. In an example, initially the overlay may be in "Black" colour; and if the overlay is correctly positioned and aligned based on the predetermined tolerances, the colour of the overlay is changed to "Green"; and if the overlay is incorrectly positioned or aligned based on the predetermined tolerances, the colour of the overlay is changed to "Red". This visual feedback allows the user to quickly and easily identify if the overlay is properly aligned and positioned, thus improving the overall accuracy of the machining process. By providing clear and easily understandable visual cues, the present disclosure enhances the user experience and reduces the risk of misalignment, which may otherwise lead to errors and inefficiencies in the CNC machining process.

In an embodiment, the list comprising the set of machining tools and the set of cutting inserts is filtered automatically based on the created 3D model of the machined part. This simplifies the tool selection process for the user by presenting only the relevant machining tools and/or cutting inserts required for the specific machining task. By automating the filtering process, the present disclosure reduces the risk of selecting inappropriate machining tools or cutting inserts, which may otherwise lead to errors and inefficiencies in the machining process, and thus contributes to a more accurate, efficient, and user-friendly CNC machining experience.

In an embodiment, a database is used for the creating the machining program for the CNC machine, the database comprising at least one of: technical drawings, machining cycles, machining features, holes, contour, threads, machining allowances, clamping information. As used herein, the "database" is an organized collection of structured information or data that may be accessed, managed, and updated to support various processes, such as creating the machining program for the CNC machine. The database may include technical drawings, machining cycles, machining features, holes, contours, threads, machining allowances, and clamping information. By utilizing the database, the present disclosure streamlines the process of creating the machining program, as it allows for the efficient retrieval and management of relevant information. For instance, including clamping information in the database helps to select the most appropriate clamping method based on the machining task, the workpiece geometry, and capabilities of the CNC machine. Similarly, including machining features in the database helps to identify the necessary machining operations, tools, and cutting inserts for the specific machining task, streamlining creation process for the machining program. This leads to a more accurate and efficient CNC machining process, as the CNC program is based on a comprehensive set of data.

In an embodiment, the machining program is automatically generated after scanning the overlay. Herein, the machining program may be automatically generated based on the user's inputs and interactions with the AR/MR device, as well as any incorporated predefined rules, algorithms, and/or information in the database. The automatic generation process may begin with the creation of the 3D model of the machined part and the provision of the blank to the CNC machine. Using the AR/MR device, the user may position and align the 3D model overlay in respect to the CNC machine, set an origin point, and select machining tools and cutting inserts. The present method may then automatically generate the machining program by considering these inputs, the specific requirements of the machined part, and any relevant constraints or parameters. By automating the generation of the machining program, the present disclosure saves time and reduces the potential for human error, resulting in a more efficient and cost-effective CNC machining process.

In an embodiment, the created machining program is transferred to the CNC machine by wire or wirelessly. It may be understood that the machining program may be created (generated) in the computing unit and may need to be transferred to the CNC machine for it configuration. This flexibility of wired or wireless transfer allows the user to choose the most suitable method of data transfer depending on the specific requirements of the CNC machine, the manufacturing environment, and the availability of network infrastructure. By providing both wired and wireless options for data transfer, the present disclosure caters to a wide range of manufacturing setups, ensuring compatibility and ease of use across different CNC machines and industries.

In an embodiment, the configuration of the CNC machine is performed wirelessly or by wire. Once the machining program, as created in the computing unit, has been transferred to the CNC machine, the control system of the CNC machine may then need to be configured to execute the said machining program, to interpret the instructions for commanding the CNC machine to perform the various operations detailed in the machining program. Such configuration may be performed directly from the computing unit either wirelessly or by wire. By providing both wireless and wired options for performing the configuration of the CNC machine, the present disclosure caters to a wide range of manufacturing setups, ensuring compatibility and ease of use across different CNC machines and industries.

The combination of AR/MR technology, automation, and comprehensive database support streamlines the process of creating machining programs, reduces errors, and improves the overall efficiency and accuracy of CNC machining. By offering flexibility in terms of scanning methods, data transfer, and CNC machine types, the present disclosure caters to a wide range of manufacturing setups and industries. Ultimately, the proposed method enhances the CNC machining process, resulting in cost-effective, accurate, and efficient production of machined parts.

The present disclosure also relates to the system as described above. Various embodiments and variants disclosed above, with respect to the aforementioned method, apply *mutatis mutandis* to the system.

In implementation of the present system, the computing unit is configured for processing user inputs, managing system resources, and executing algorithms and processes required for purposes of the present disclosure. The computing unit may be a standalone device or integrated into the AR/MR device, depending on the specific requirements of the system. The computing unit may include a central processing unit (CPU), memory, storage, and input/output (I/O) components, all interconnected through a communication bus or the like. Further, the computing unit may be connected to the AR/MR device and the CNC machine through wired or wireless communication protocols, such as Wi-Fi, Bluetooth, Ethernet, or any other suitable communication standard.

In the system, the computing unit is configured to use the AR/MR device as the user interface, providing an intuitive and interactive way for users to engage with the system while creating the machining program and configuring the CNC machine. The AR/MR device serves as a bridge between the user and the computing unit, allowing users to input data, make selections, and visualize the machining process in an immersive, real-time environment. Through the AR/MR device, users may render the 3D model of the machined part as the overlay to the blank, position and align the overlay with respect to the CNC machine, and set the origin point for CNC machining. Additionally, the AR/MR device enables users to select machining tools and cutting inserts from the said list, tip the surface of the blank with the selected tool or insert, and approve or disapprove presented machining cycles. The computing unit processes these user inputs and interactions, automatically generating the machining program based on the data provided through the AR/MR device. The computing unit also leverages the AR/MR device to simulate the created machining program, offering users the ability to visualize the CNC machine's operation and make necessary refinements before initiating the actual machining process.

Herein, the user interface provided by the AR/MR device is an interactive and immersive graphical display, comprising a set of virtual buttons and visual aids that enable the operator to interact with and control various aspects of the CNC machining process. The user interface is designed to enhance the operator's experience by integrating augmented and mixed reality elements, which can be accessed and manipulated through the AR/MR device. In one or more examples, the user interface may include, but not limited to, (i) "Turn on the compressor" button which is used to activate the compressor in the CNC machine setup which is necessary for the proper functioning of the machine; (ii) "Turn on the CNC machine" button which is used to initiate the operation of the CNC machine, ensuring it is ready to execute the machining program; (iii) "Technical drawing" button which may upon selecting (by clicking or tapping) may further provide: "2D drawing button" which displays a 2D technical drawing of the machined part providing a visual reference for the operator, and "3D model button" which displays the 3D model of the machined part in the AR/MR device allowing for a more immersive and interactive experience; (iv) "Measurement tools" button which provides access to various measurement tools that can be used to measure dimensions and verify tolerances during the machining process; (v) "Oils in the machine" button which displays information about the lubrication status of the CNC machine ensuring that proper maintenance is performed; (vi) "Material" button which provides information about the material of the blank including its properties and suitability for the machining process; (vii) "Program" button which allows the operator to access and preview the machining program stored in the database providing insight into the steps that the CNC machine will execute; (viii) "Machining tool/cutting insert" button which provides information about the cutting tools and inserts available for use in the CNC machine allowing the operator to select the most suitable tool for the task; (ix) "Necessary tools and parts to attach the material" button which offers guidance on the tools and attachments needed to securely mount the blank in the CNC machine; (x) "Clamping system" button which provides visual aids such as photos and videos, as well as the option to display 3D models with AR/MR holograms to demonstrate the proper mounting of the blank in the CNC machine by using indication with different colours like, for example, Green and Red; (xi) "Zero/Origin point" button which enables the operator to set the origin point for the CNC machining process indicating where dimensions will be measured from; (xii) "Simulate program" button which initiates a simulation of the machining program providing a visual preview of the machining process before it is executed on the CNC machine; (xiii) "Rotate/Lift" button which allows the operator to manipulate the virtual 3D model in the AR/MR device enabling them to rotate and lift the model for improved visibility and understanding; (xiv) "Processing time" button which provides an estimation of the total processing time required for the machining program to be executed by the CNC machine allowing the operator to plan and optimize the workflow efficiently; and (xv) "Remove errors in the machine" button which assists the operator in identifying and resolving any errors or issues that may arise during the CNC machining process ensuring smooth and efficient operation of the CNC machine.

In an example, the "Machining tool/cutting insert" button in the AR/MR device's user interface streamlines the process of selecting and verifying the appropriate tools and cutting inserts for the CNC machining operation. By clicking on this button, the operator activates the AR/MR device's camera, which is then used to scan the physical machining tool or cutting insert in the CNC machine or workstation. Herein, when the operator scans a machining tool, such as a milling head, the AR/MR device's software analyses the scan and displays a photo with information on compatible cutting inserts that can be used with the scanned machining tool. This functionality allows the operator to quickly identify and select the correct cutting inserts for the specific machining task, ensuring optimal performance and reducing the risk of errors. Alternatively, by scanning a cutting insert, the AR/MR device's software displays a photo of the machining tools that are compatible with the scanned cutting insert. This feature helps the operator to easily determine which machining tools are suitable for use with a specific cutting insert, further simplifying the process of machining tool selection and improving the overall efficiency of the CNC machining operation.

The present disclosure also relates to the machining program as described above. Various embodiments and variants disclosed above, with respect to the aforementioned method and the aforementioned system, apply *mutatis mutandis* to the machining program.

The machining program may significantly enhance the CNC machining process by leveraging AR/MR technology to streamline the programming and operation of the CNC machine. The machining program may be generated by the present method using autonomous programming based on artificial intelligence (AI). Herein, when scanning a part or machine using AR/MR technology, the method may automatically identify machining features and retrieves technical drawings based on information about machining tools, cycles, holes, contours, threads, and machining allowances. Thereafter, the method may evaluate the most convenient origin point options based on the identified features and saves this information to the database. Utilizing the collected data, the method may generate a comprehensive machining program that is tailored to the specific part and machine being used. This intelligent programming approach ensures optimal efficiency and precision during the CNC machining process.

The present disclosure significantly improves the CNC machine configuration process by using AR/MR technology, offering numerous advantages over conventional methods. The present disclosure addresses the limitations of conventional CNC programming and machine setup, by increasing efficiency, reducing water, enhancing user experience and providing improved safety. The scalability and adaptability of the present disclosure make it suitable for a wide range of applications and industries, including but not limited to aerospace, automotive, medical devices, consumer electronics, and more. The present disclosure by incorporation of AR/MR technology allows for the possibility of remote collaboration and support. Experts or team members from different locations can view and manipulate the 3D model, provide real-time feedback, and make adjustments to the machining program, facilitating efficient and effective communication among team members. This capability is particularly valuable in industries with global supply chains and large-scale manufacturing operations. Additionally, the present disclosure may facilitate the development of new training and educational programs for CNC machine operators.

### DETAILED DESCRIPTION OF THE DRAWINGS

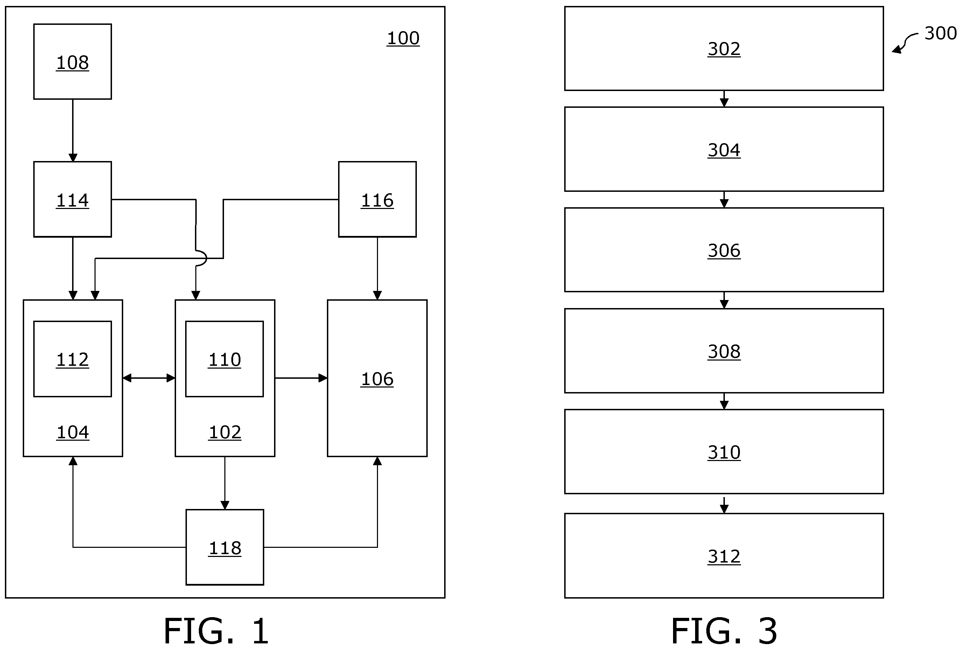

Referring to FIG. 1, illustrated is a schematic block diagram of a system 100 for configuring a CNC machine to machine a blank to a machined part, in accordance with an embodiment of the present disclosure. As illustrated, the system 100 includes a computing unit 102, an AR/MR device 104, a CNC machine 106, and a scanner 108 in the form of laser scanning (LIDAR) or a camera or video. The CNC machine 106, as represented, may be a part of the system 100 as a virtual CNC machine, or alternatively a physical CNC machine outside of the system 100 (not shown). The computing unit 102 includes a database 110 to access and store relevant data, such as technical drawings, machining cycles, machining features, holes, contour, threads, and machining allowances. The AR/MR device 104 is connected to the computing unit 102, enabling the computing unit 102 to use the AR/MR device 104 to provide a user interface 112 for interacting with a user during the process of configuring the CNC machine 106. The scanner 108 generates a 3D model of the machined part 114. The AR/MR device 104 renders the 3D model of the machined part 114 as an overlay to a blank 116, positions and aligns the overlay with respect to the CNC machine 106, and provides indication if the overlay is positioned and aligned based on predetermined tolerances. The computing unit 102 creates a machining program 118. The AR/MR device 104 presents and simulates the machining program 118 for the user for approval/disapproval. The computing unit 102 configures the CNC Machine 106 with the created machining program 118 if approved.

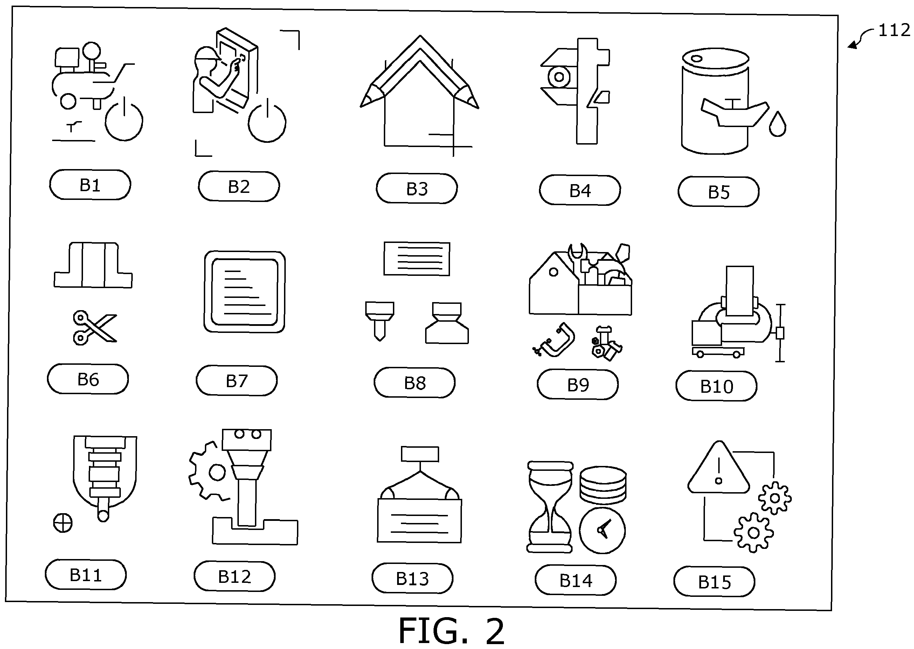

Referring to FIG. 2, illustrated is an exemplary depiction of the user interface 112, in accordance with an embodiment of the present disclosure. As illustrated, the user interface 112 includes a "Turn on the compressor" button 'B1' associated with corresponding icon, a "Turn on the CNC machine" button 'B2' associated with corresponding icon, a "Technical drawing" button 'B3' associated with corresponding icon, a "Measurement tools" button 'B4' associated with corresponding icon, a "Oils in the machine" button 'B5' associated with corresponding icon, a "Material" button 'B6' associated with corresponding icon, a "Program" button 'B7' associated with corresponding icon, a "Cutting tools" button 'B8' associated with corresponding icon, a "Necessary tools and parts to attach the material" button 'B9' associated with corresponding icon, a "Clamping system" button 'B10' associated with corresponding icon, a "Zero/Origin point" button 'B11' associated with corresponding icon, a "Simulate program" button 'B12' associated with corresponding icon, a "Rotate/Lift" button 'B13' associated with corresponding icon, a "Processing time" button 'B14' associated with corresponding icon, and a "Remove errors in the machine" button 'B15' associated with corresponding icon.

Referring to FIG. 3, illustrated is a flowchart listing steps involved in a method 300 for configuring a CNC machine to machine a blank to a machined part, in accordance with an embodiment of the present disclosure. At step 302, the method 300 includes creating a 3D model of the machined part. At step 304, the method 300 includes providing the blank to the CNC machine. At step 306, the method 300 includes using an AR/MR device for: rendering the 3D model of the machined part, as an overlay to the blank; positioning and aligning the overlay in respect to the CNC machine; providing indication if the overlay is positioned and aligned based on predetermined tolerances; and setting an origin point by selecting a point on the overlay, wherein the origin point indicates where one or more dimensions for CNC machining begin. At step 308, the method 300 includes creating a machining program for the CNC machine to machine the blank to the machined part, by repeating steps (i),(ii),(iii),(iv), until the machining program is ready for simulation by using the AR/MR device for: (i) selecting a machining tool and/or a cutting insert from a list comprising a set of machining tools and a set of cutting inserts; (ii) tipping a surface of the blank with the selected machining tool or cutting insert; (iii) presenting a machining cycle for machining the blank to the machined part; and (iv) approving or disapproving the presented machining cycle and including the approved machine cycle in the machining program. At step 310, the method 300 includes simulating the created machining program. At step 312, the method 300 includes configuring the CNC machine with the created machining program.

## Claims

1. A method (300) for configuring a Computer Numerical Control (CNC) machine (106) to machine a blank (116) to a machined part, the method (300) comprising:
- creating a 3D model of the machined part (114);
- providing the blank (116) to the CNC machine (106);
- using an Augmented-Reality (AR)/ Mixed-Reality (MR) device (104) for:
- rendering the 3D model of the machined part (114), as an overlay to the blank (116);
- positioning and aligning the overlay in respect to the CNC machine (106);
- providing indication if the overlay is positioned and aligned based on predetermined tolerances;
- setting an origin point by selecting a point on the overlay, wherein the origin point indicates where one or more dimensions for CNC machining begin;
- creating a machining program (118) for the CNC machine (106) to machine the blank (116) to the machined part, by repeating steps (i),(ii),(iii),(iv), until the machining program (118) is ready for simulation by using the AR/MR device (104) for:
(i) selecting a machining tool and/or a cutting insert from a list comprising a set of machining tools and a set of cutting inserts;
(ii) tipping a surface of the blank (116) with the selected machining tool or cutting insert;
(iii) presenting a machining cycle for machining the blank (116) to the machined part;
(iv) approving or disapproving the presented machining cycle and including the approved machine cycle in the machining program (118);
- simulating the created machining program (118); and
- configuring the CNC machine (106) with the created machining program (118), the method further comprising:
- transferring the created machining program to a control system of a physical CNC machine, wherein the control system interprets instructions and commands for the physical CNC machine to perform various operations detailed in the created machining program, so that actual machining process is initiated.

2. A method (300) according to claim 1, wherein the provided blank (116) is a virtual model blank (116).

3. A method (300) according to claim 1 or 2, wherein the CNC machine (106) is a virtual CNC machine (106).

4. A method (300) according to any of claims 1 to 3, wherein the overlay is a holographic model.

5. A method (300) according to any of claims 1 to 4, wherein the configuration of the CNC machine (106) is performed wirelessly or by wire.

6. A method (300) according to any of claims 1 to 5, wherein the created machining program (118) is transferred to the CNC machine (106) by wire or wirelessly.

7. A method (300) according to any of claims 1 to 6, wherein the provided indication if the overlay is positioned and aligned based on predetermined tolerances is performed by changing colour of the overlay.

8. A method (300) according to any of claims 1 to 7, wherein laser scanning (LIDAR) or a camera or video (108) or a combination of the aforementioned is used for scanning an object for creating the 3D model of the machined part (114).

9. A method (300) according to any of claims 1 to 8, wherein the list comprising the set of machining tools and the set of cutting inserts is filtered automatically based on the created 3D model of the machined part (114).

10. A method (300) according to any of claims 1 to 9, wherein a database (110) is used for the creating the machining program (118) for the CNC machine (106), the database (110) comprising at least one of: technical drawings, machining cycles, machining features, holes, contour, threads, machining allowances, clamping information.

11. A method (300) according to any of claims 1 to 10, wherein the origin point is selected automatically using parameters related to model of the CNC machine (106).

12. A method (300) according to claim 8, wherein machine vision is used for scanning the object.

13. A system (100) for configuring a Computer Numerical Control (CNC) machine (106) to machine a blank (116) to a machined part, the system (100) comprising:
- an Augmented-Reality (AR)/ Mixed-Reality (MR) device (104) for:
- rendering the 3D model of the machined part (114), as an overlay to the blank (116);
- positioning and aligning the overlay in respect to the CNC machine (106);
- providing indication if the overlay is positioned and aligned based on predetermined tolerances;
- setting an origin point by selecting a point on the overlay, wherein the origin point indicates where one or more dimensions for CNC machining begin; and
- a computing unit (102) for creating a machining program (118), the computing unit (102) configured to use the AR/MR device (104) as user interface (112) for:
(I) selecting a machining tool and/or a cutting insert from a list comprising a set of machining tools and a set of cutting inserts;
(II) tipping a surface of the blank (116) with the selected machining tool or the cutting insert;
(III) presenting a machining cycle for machining the blank (116) to the machined part;
(IV) approving or disapproving the presented machining cycle and including the approved machine cycle in the machining program (118),
wherein the computing unit (102) is configured to simulate the created machining program (118) and configure the CNC machine (106) with the created machining program (118),
- wherein the created machining program is transferred to a control system of a physical CNC machine, and wherein the control system interprets instructions and commands for the physical CNC machine to perform various operations detailed in the created machining program, so that actual machining process is initiated.

14. A machining program (118), according to the method (300) of claim 1, wherein the created machining program (118) is installed on the CNC machine (106).
